# EUROPEAN PATENT SPECIFICATION

(11) **EP 0 768 141 B1**
(45) Date of publication and mention of the grant of the patent: **31.07.2002**
(21) Application number: 96116135.3
(22) Date of filing: 09.10.1996
(51) Int. Cl.: B23Q 1/62, B26D 7/01, B26D 5/08, H02K 41/035, H05K 3/00

(54) **Punching machine**
Lochstanzmaschine
Machine pour le poinçonnage

(30) Priority: 12.10.1995 IT UD950202
(43) Date of publication of application: 16.04.1997
(73) Proprietor: Baccini, Gisulfo, I-31030 Mignagola di Carbonera (TV) (IT)
(72) Inventor: Baccini, Gisulfo, I-31030 Mignagola di Carbonera (TV) (IT)
(74) Representative: Petraz, Gilberto Luigi

(56) References cited:
- EP-A- 0 236 766
- EP-A- 0 423 052
- DE-A- 3 123 759
- DE-A- 3 809 140
- DE-C- 959 182
- FR-A- 2 239 316
- US-A- 4 506 204
- US-A- 4 829 375
- US-A- 5 228 358
- IBM TECHNICAL DISCLOSURE BULLETIN, vol. 16, no. 12, May 1974, NEW YORK US, page 3921 XP002022739 MELVIN: "programmable cluster punching system"
- PATENT ABSTRACTS OF JAPAN vol. 14, no. 147 (M-952) 20 March 1990 & JP-A-02 011 234 (CANON INC.) 16 January 1990
- IBM TECHNICAL DISCLOSURE BULLETIN, vol. 12, no. 12, May 1970, NEW YORK US, page 2171 XP002022740 MELVIN: "rotatable fixture for ganged punches"
- PATENT ABSTRACTS OF JAPAN vol. 18, no. 641 (E-1639) 06 December 1994 & JP-A-06 024 548 (FUJI ELECTRIC CO.)
- IBM TECHNICAL DISCLOSURE BULLETIN, vol. 20, no. 4, September 1977, NEW YORK US, pages 1379-1380, XP002022741 COCHRAN ET AL.: "automated punch apparatus for forming via holes in a ceramic green sheet"
- IBM TECHNICAL DISCLOSURE BULLETIN, vol. 32, no. 7, December 1989, NEW YORK US, pages 255-257, XP000078090 "via punching device for multi-layered ceramic substrares"

## Description

This invention concerns a punching machine, as set forth in the main claim.

The punching machine according to the invention is applied advantageously, even though not only, to the field of the preparation of substrates for electrical micro-circuits, such as green-tape sheets for instance, these green-tape sheets being then assembled to form a multi-layer circuit.

The state of the art includes punching machines with movement on three axes, the machines being used to prearrange substrates intended for the embodiment of multi-layer electrical circuits.

These punching machines are employed to obtain in the substrate micro-holes which are then filled in a subsequent operation with a conductive paste to embody the required electrical connections.

The punching machines of the state of the art normally include a supporting table on which is rested, normally in a rigidly constrained manner, the substrate to be punched; this supporting table is capable of movements on two axes of the horizontal plane so as to position correctly the substrate in relation to the punching assembly.

The punching assembly is normally associated with a vertical stand and is moved by a relative controlled actuation.

In the state of the art the actuations of the table on the horizontal plane and the vertical actuation of the punching assembly are normally produced by kinematic systems including actuators of an electrical type or of another substantially conventional type.

These conventional actuators generally comprise screw means solidly associated with the table to be moved, and these screw means cooperate with supports, bearings, lubrication conduits and other auxiliary components required for their correct working.

The kinematic systems of the state of the art have often been found to be unsuitable for the specific use required by the technology of the punching of substrates for electrical circuits and in particular by the technology of the processing of the green-tape sheets .

In particular, the conventional systems often cannot ensure those characteristics of determination, accuracy and speed required simultaneously in the making of micro-holes which then define the electrical circuit consisting of the multi-layer pack of green-tape sheets.

To be more exact, the conventional systems, even with special contrivances, can only achieve the required accuracy at the expense of the speed and therefore of the output of the plant.

Moreover, such systems are mechanically complex, require great maintenance, suffer from premature wear of their component parts, and in particular of the bearings, and also entail great energy consumption and difficult adjustment.

Another shortcoming which is encountered consists in the difficulty of ensuring an equilibrated and balanced movement of the punch in all its working positions when it is acting on the substrate.

Another shortcoming not resolved in the state of the art is to ensure a wide range of travel and therefore a high flexibility of positioning on the axis x-y of the article to be punched, in order to design an integrated machine which can accomplish the punching operation by progressively picking up the articles from a feeding line.

Another shortcoming in the state of the art in this type of machine is that the articles are normally rigidly fixed to the support, this being due to the fact that it is substantially impossible to correct any errors of positioning which might occur deriving from undesired movements and displacements of the article when it is being positioned under the punching element.

This involves problems of handling, discharge, possible deterioration, the use of glues, etc.

Partial solutions have been proposed which use punching elements driven by linear motors (see EP-A-423.052 or the IBM Technical Disclosure Bulletin vol. 33, n°. 4, September 1990), but these solutions have not been included in the global context of an integrated punching machine, and they have not solved the problems of productivity and precision that the technology of green-tape production involves.

Document XP002022739, which represents the closest state of the art, discloses a punching machine for substrates of microcircuits including a supporting table movable on two axes (x, y) and a punching element movable only on a vertical axis (z) and not rotatable for the positioning with respect to the workpiece.

US-A-5,228,358 discloses a motion guiding device comprising tables movable on axes x and y and actuated by linear motors on pneumostatic supports.

The present applicant has designed, tested and embodied this invention to overcome these shortcomings of the state of the art and to achieve further advantages.

This invention is set forth and characterised in the main claim, while the dependent claims describe variants of the idea of the main embodiment.

The purpose of the invention is to embody a punching machine which works on four axes, that is the three axes x, y, z of the Cartesian plane, plus a rotation axis θ for the initial positioning of the punching element with respect to the article to be punched, in which punching machine at least the actuations on the three axes x, y and z are carried out by means of linear motors.

According to a variant, the actuation of the rotation with respect to the axis θ is carried out by means of a linear motor.

According to another feature of the invention, at least the movement of the article to be punched on the axis x and y is carried out on pneumostatic tables, that is tables which move on a cushion of air formed by jets of air.

According to another feature of the invention, also the punching element which moves on the axis z is supported and guided on a pneumostatic column which acts as a cushion of air.

The linear motors used to move the pneumostatic movable tables on the axis x-y and the punching element along the axis z can be substantially of any known type.

In the preferred but non restricted embodiment of the invention, the motors used are of the voice coil type, that is, the type that makes use, as its working principle, of the generation of a force on a conductor through which a current passes and which is immersed in an electromagnetic field, and which includes precise ratios in size between the coils and the magnets in order to maximalise the yield of the motor itself.

A linear motor of this type comprises a first movable part and a second stationary part, of which the first comprises a plurality of permanent magnets or electromagnets fitted side by side on supports with reciprocally alternating polarity, whereas the second comprises a plurality of coils or windings associated with a core of a ferromagnetic material.

It is also possible to have a motor with stationary magnets and movable coils.

The coils are fed singly and independently in a variable manner according to the polarity of the magnet facing them at the specific moment, however it is possible to switch over the direction of flow of the currents in order to ensure, during the reciprocal displacement of the coils and magnets, the correct conditions relating to the signs of the current, the magnetic field and the force generated.

The magnets are spaced apart from each other at a distance which corresponds substantially to the pitch of the coils.

In the punching machine according to the invention, the linear motors which move the pneumostatic tables along the axes x-y, because of their high speed, may be considered as being composed of a plurality of voice coil motors assembled together to constitute a single drive unit.

The configuration and number of the linear motors relative to each axis may vary according to the weight to be moved, to the performance required and to the particular processing specifications.

In particular, magnets may be included in cooperation with one or more surfaces of the coil, depending on the power required of the motor relative to a specific axis.

Moreover, in relation to the load to be moved and also for reasons of equilibration, each axis may comprise one or more linear motors arranged symmetrically in relation to that axis.

The employment of linear motors, and particularly of motors which function according to the voice coil principle, in a punching machine enables, in combination with pneumostatic support systems and without the addition of special contrivances, the output of the machine to be increased up to three times while maintaining and even improving the characteristics of accuracy and repeatability, this condition being especially important in processing relating to the preparation of electrical micro-circuits.

So as to achieve the same accuracies, the traditional systems are compelled to use auxiliary linear encoders, thus reducing considerably the speed of positioning and entailing a very long time of stabilisation of the axis.

Moreover, the speed of execution is increased and the rejects due to mistakes in execution are reduced, thus leading to an increase of productivity of the machine.

Furthermore, the structure of the machine is lighter and simpler to construct and requires less maintenance and less replacement of the component parts.

According to one embodiment of the invention, the punch-bearing plate supports at least two punching heads moved by the same drive unit, each punching head being arranged to cooperate with a specific sector of the article to be punched.

According to another embodiment, the punch-bearing plate supports a plurality of punching heads, each of which is driven by the relative linear motor; this solution makes the punching operation extremely flexible in that each punch is driven independently and autonomously with respect to the other, and thus it is possible, for example, to achieve punches with different diameters and different designs.

According to a variant of the invention special linear motors are employed which include terminal magnets consisting of half poles or of magnets which have a length equal to half of the length of the other intermediate magnets, with the other dimensions equal.

The use of this type of motors enables cores to be employed which have a capacity of flow transmission that can be half of that of the cores employed at present, with a resulting reduction of section and therefore of weights and volumes.

This reduction may reach at least 50% in weight as compared to conventional linear motors.

This reduction of the masses and weights involved enables a linear motor to be obtained which, given an equal number of poles, provides a better electrical response, greater acceleration and therefore quicker positioning with almost negligible times for stabilisation of position as compared to the motors of the state of the art.

The attached figures are given as a non-restrictive example and show a preferred embodiment of the invention as follows:
- Fig.1: shows a front view of the punching machine according to the invention;
- Fig.2: shows a side view of the punching machine according to the invention;
- Fig.3: shows a plan view of the punching machine according to the invention;
- Fig.4: shows a longitudinal section of the horizontal assembly of the punching machine according to the invention;
- Fig.5: shows a view from above of the assembly of Fig. 4;
- Fig.6: shows a transverse section of the assembly of Fig. 4;
- Fig.7: shows in an enlarged scale a longitudinal half-section/half-view of the vertical punching actuator assembly according to the invention.

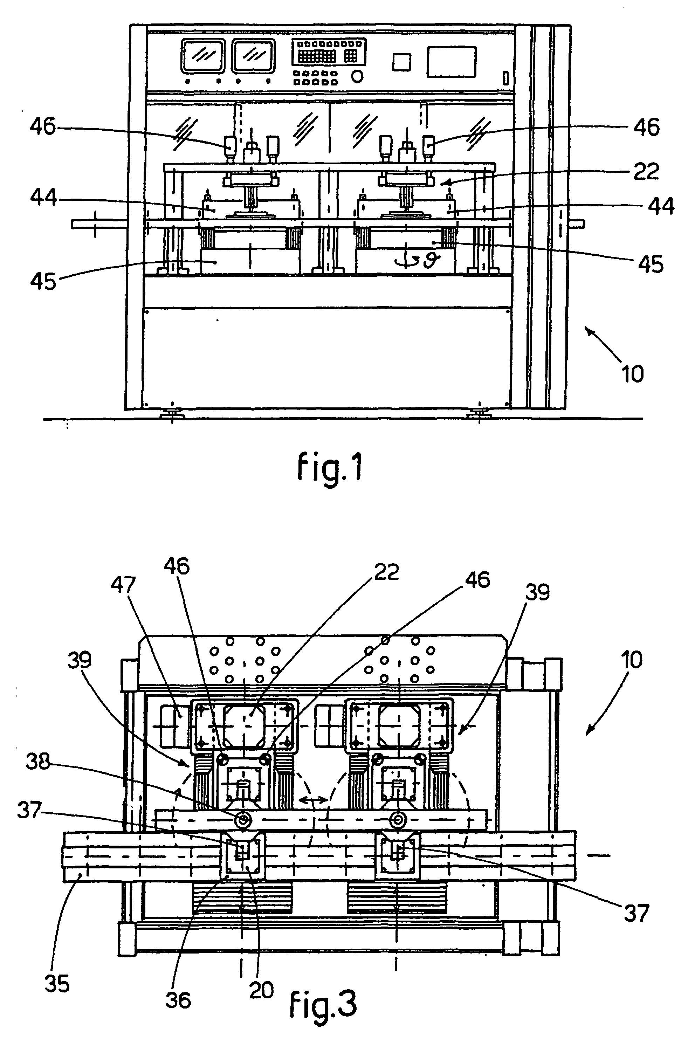

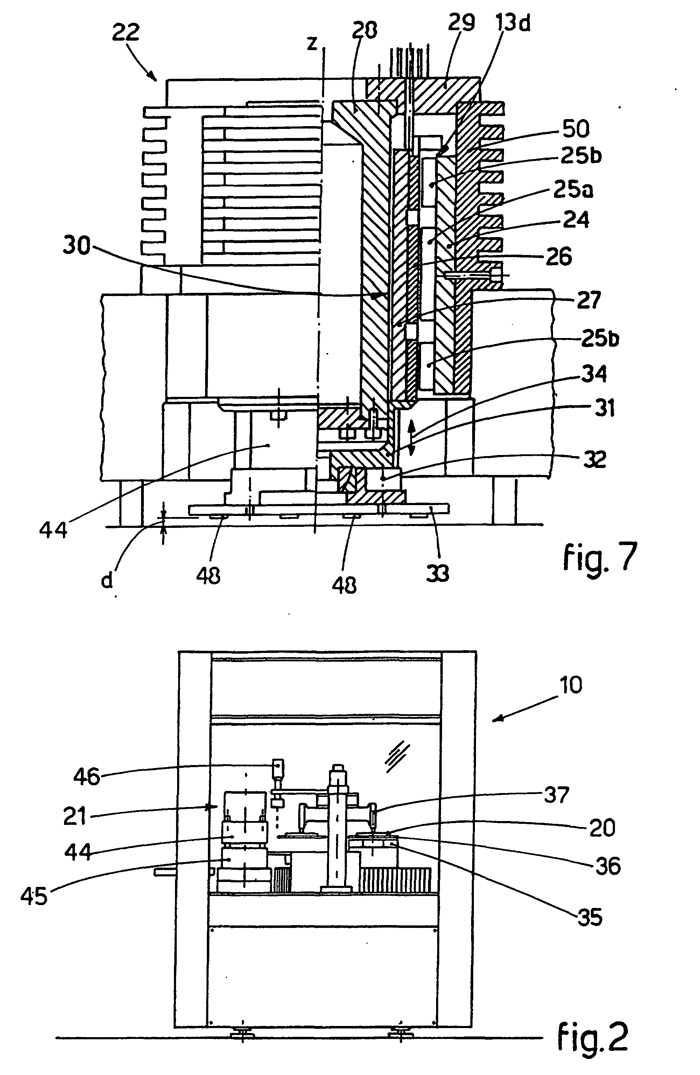

The punching machine 10, shown diagramatically in its entirety in Figs. 1 to 3, comprises a feeding line 35 which progressively carries the articles to be punched 20, in this case an alumina substrate to make green-tape circuits and resting on a support 36, to the punching assembly proper 39.

In the case shown, the punching machine 10 comprises two punching assemblies 39.

Moreover, in this case, the punching machine 10 has at the rear a service area 49 used for changing the moulds.

The substrates 20 are picked up by a handling device 37 which, rotating on its column 38, deposits them on the horizontal assembly 40 of the punching machine 10.

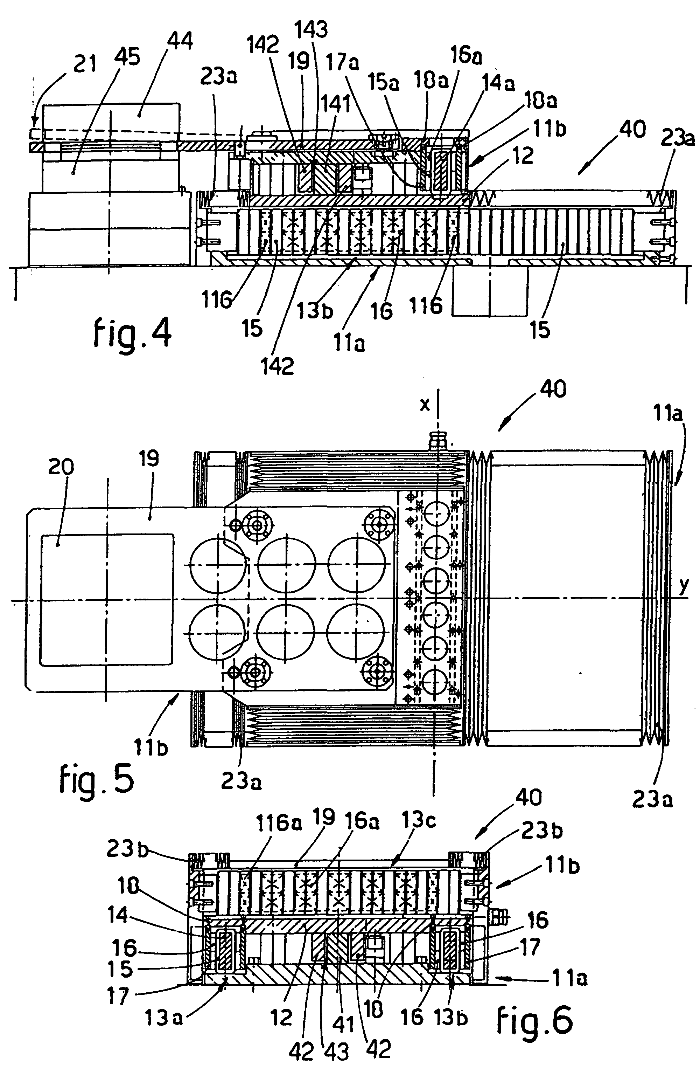

The horizontal assembly 40 is shown in Figs. 4-6 and comprises a first assembly 11a movable along the axis y and a second assembly 11b movable along the axis x.

The first assembly 11a movable along the axis y comprises a first flat table 12 displaceable in the direction of the axis y; this displacement is provided by a pair of linear motors 13, which are respectively 13a and 13b and are positioned symmetrically opposite to each other in relation , to the axis y and are connected together electrically.

In this case each linear motor 13 comprises a ferromagnetic core 14 on which are wound a plurality of coils 15.

A plurality of magnets 16 are included in cooperation with the coils 15 and face in this example on both sides of the coils 15 and are spaced equally apart at a reciprocal distance equal to the lateral dimension of each coil 15 and have a sequentially alternate polarity, so as to achieve the multiple configuration of the voice coil motor.

In this case two superimposed magnets 16 are included at each side of the coil 15, in order to minimise the disuniformity of flow which occurs in correspondence with the corners of each magnet 16.

Each pair of superimposed magnets 16 forms one pole of the linear motor 13.

In this case the two linear motors 13a and 13b comprise pairs of terminal magnets 116, which have a width equal to half of the width of the other magnets 16, so that their presence at the ends of the support 17 causes the magnetic flow coming out from the adjacent magnet to divide into two equal parts, one which closes on the half pole 116 and the other closing on the magnet placed on the other side.

This makes possible the use of cores 14 which have a greatly reduced section of about a half of those normally used since these cores 14, given an equal flow transmitted, require a substantially halved transmitting "capacity".

This situation entails a reduction of the copper surrounding the core and therefore a lesser dissipation and a greater efficiency, given an equal mechanical power.

This also has the effect that this type of linear motor 13 is able to provide a better electrical response, a greater acceleration and a faster positioning, these being parameters which are especially important when applied to punching machines.

The magnets 16, 116 are solidly fixed to relative supports 17, which are firmly secured to the first flat table 12 by fixture elements 18.

The first flat table 12 supports and moves the assembly 11b movable along the axis x.

The flat table 12 moves on a transverse pneumostatic support system determined by the cushion of air which forms between the central guide 41 and the pneumostatic columns 42 placed at the sides.

There are similar longitudinal pneumostatic support systems not visible in the Figure.

Between the central guide 41 and the pneumostatic columns 42 a chamber 43 is formed which is filled by a flow of air fed into the pneumostatic columns 42, said air then coming out of the pneumostatic columns 42 by means of the appropriate holes present in the surface.

The assembly 11b movable along the axis x in turn comprises a second flat table 19 moved along the axis x by a relative linear motor 13c.

This linear motor 13c has a configuration with half poles analogous to that of the motors 13a, 13b described above, with relative coils 15a wound on a stationary core 14a and with relative intermediate magnets 16a and terminal magnets 116a.

In this case too the magnets 16a, 116a are firmly secured to a relative support 17a, which is anchored to the second flat table 19 by means of relative fixture elements 18a.

The flat table 19 also moves on a pneumostatic support, its transverse element comprises the central guide 141 and the pneumostatic columns 142 at the side, defining the relative chamber 143.

The substrate to be punched 20 is rested on the second flat table 19.

The horizontal assembly 40 further includes shock absorber means, respectively 23a on the axis y and 23b on the axis x, and positioned on opposite sides of the first flat table 12 and the second flat table 19 respectively.

The combination of the actuations along the axis y by the linear motors 13a and 13b and along the axis x by the linear motor 13c enables the substrate 20 to be positioned very quickly and accurately, and with almost negligible times for stabilisation of position, in cooperation with the stand 21 on which the punching actuator 22 is placed.

To insert the substrate 20 it is necessary to lift the end section of the table 19 (see the line of dashes in Fig.4), to position the substrate 20 between the mould part 44 and the matrix part 45, kept apart by the punching actuator 22.

Immediately before this step, two video cameras 46 verify the correct positioning in a rotational direction of the substrate 20 with respect to the punching stand 21.

In fact, since the substrate 20 is only rested on the flat table 19, the movements made to insert it by the feeding line 35 towards the punching stand 21, can alter its correct positioning.

The video cameras 46 cooperate, in order to verify the positioning, with the appropriate reference signs, such as holes, marks, notches or the like, on the substrate 20 or even the edge itself.

If the positioning is not correct, the video cameras 46 send a correction signal to an actuator 47, in this case a linear motor, which starts to rotate the entire punching stand 21 according to the axis θ. and positions the mould 44 and the matrix 45 in the correct reciprocal position with respect to the substrate 20.

This punching actuator 22 is shown in a longitudinal half-section/half-view in Fig.7.

In this example the actuator 22 comprises an outer stationary body 50, to which are solidly secured the stationary magnet-holder plates 24 of the linear motor 13d.

In this case each magnet-holder plate 24 supports a central magnet 25a and two terminal half magnets 25b to form a motor with two poles. On four sides the magnets 25a and 25b face coils 26 wound onto a movable core 27.

The movable core 27 cooperates with a pneumostatic central stationary column 28 secured to the outer body 50 through a retaining flange 29.

Between the pneumostatic central stationary column 28 and the movable core 27 a pneumostatic sliding surface 30 is defined which is full of air under pressure, the air coming out from holes on the periphery of the central pneumostatic column 28.

The movable core 27 supports through a connecting element 31 a punch-holder head 32, to which is fitted an actual punching element 33, which is displaceable along the direction 34 according to the actuation of the linear motor 13d.

The punches 48 are on this punch-bearing plate 33.

The travel "d" of the linear motor 13d is extremely limited and is substantially equal to the difference between the vertical size of the coils 26 and the vertical size of the magnets 25 which face them (see Fig. 7).

This configuration means that always and in every position the coils 26 are facing the relative magnet 25, which makes the efficiency of the motor 13d extremely high and allows very high frequencies to be used.

According to one embodiment of the invention the punches 48 are distributed on the punch-bearing plate 33 in such a way that each of them cooperates with a specific and definite sector of the substrate 20 in relation to the movement on the axis x-y imparted by the flat table 19.

This makes it possible to reduce production times because, in the case of punching designs which can be divided symmetrically into defined sectors, these sectors are affected at the same time by the action of the punches 48 which are moved at the same time.

In the event that the punching designs are not symmetrical for the various sectors, one or another of the punches 48 may be removed from the punch-bearing plate 33.

According to a variant not shown here, the punch-bearing plate 33 supports a plurality of punches 48, each of which is associated with a relative actuator, for example a linear motor, autonomously and independently actuated in relation to the punching design to be achieved.

This embodiment makes the punching machine 10 extremely versatile and flexible, making it possible to achieve extremely varied designs, with holes of a different diameter, and greatly reducing the working cycle times.

## Claims

1. Punching machine employed in the pre-arrangement of substrates (20) for electrical micro-circuits such as, for instance, green-tape sheets, the machine including a supporting table movable on the two axes (x, y) of the horizontal plane in cooperation with a punching stand (21), the punching stand (21) supporting a movable punching actuator according to a vertical axis (z) and having at the lower part a mould element (44) and a matrix element (45), the machine being **characterised in that** the flat table (19) which supports the substrate (20) is movable along the axis (x) and is rigidly associated at the lower part with a flat table (12) movable along the axis (y), **in that** at least the actuations of the flat table (19) along the axis (x), and those of the flat table (12) along the axis (y) and the punching actuator (22) along the axis (z) are obtained by means of linear motors (13a, 13b, 13c, 13d) arranged with their axis parallel to the respective axis of positioning (x, y, z), **in that** at least the flat tables (12, 19) move on a relative pneumostatic support and guide system (41, 42, 43; 141, 142, 143), **in that** the punching actuator (22) is associated with a pneumostatic support and guide system (28, 30), and **in that** said punching stand (21) is associated with a rotation actuator (47) with respect to an axis θ for the correct positioning with respect to the substrate (20).

2. Punching machine as in Claim 1, in which the rotation actuator (47) is a linear motor.

3. Punching machine as in Claims 1 or 2, in which the rotation actuator (47) of the punching stand (21) is governed by video cameras (46) to verify the correct polar position of the substrate (20).

4. Punching machine as in any claim hereinbefore, in which the linear motors (13a, 13b, 13c) to position the flat tables (12, 19) with respect to the axes x-y are linear motors of the multiple voice coil high-travel type and include a plurality of magnets (16, 16a) secured to a relative movable support (17, 17a) and facing towards current conductor elements (15, 15a), these current conductor elements (15, 15a) being wound on a relative core (14, 14a) and being fed independently and autonomously according to the relative position of facing towards the magnets (16, 16a).

5. Punching machine as in any claim hereinbefore, in which the linear motor (13d) to drive the punching actuator (22) with respect to the axis (z) is a linear motor of the voice coil limited travel type, and has stationary magnet-bearing plates (24) arranged to cooperate peripherically with a movable core (27) supporting the coil (26).

6. Punching machine as in Claim 5, in which the travel (d) of the linear motor (13d) is equal to the difference between the vertical size of the coil (26) and the vertical size of the magnets (25) which face them.

7. Punching machine as in any claim hereinbefore, in which at least one of the linear motors (13a, 13b, 13c, 13d) is of the type having end half poles.

8. Punching machine as in any claim hereinbefore, in which the punching actuator (22) has on the lower part a punch-bearing plate (33) supporting at least a pair of punches (48) to act simultaneously on the substrate (20).

9. Punching machine as in any claim from 1 to 7 inclusive; in which the punch-bearing plate (33) supports a plurality of punches (48) each of which is associated with a relative actuator which is driven independently and autonomously.

10. Punching machine as in any claim hereinbefore, which has one or more punching assemblies (39) associated with a feeding line (35).

11. Punching machine as in any claim hereinbefore, which has rotating handling devices (37) to transfer the substrates (20) from the feeding line (35) to the flat table (19).

12. Punching machine as in any claim hereinbefore, which has at the rear part a service area (49) to change the moulds.

## Patentansprüche

1. Lochstanzmaschine zur Verwendung bei der Vor-Ausrichtung von Substraten (20) für elektrische Mikroschaltungen wie z.B. Grünling-Band-Folien, mit einem auf den beiden Achsen (x, y) der horizontalen Ebene in Zusammenwirken mit einem Lochstanzgerüst (21) beweglichen Auflagetisch, wobei das Lochstanzgerüst (21) einen beweglichen Lochstanz-Antrieb entsprechend einer vertikalen Achse (z) und am unteren Teil ein Formelement (44) und ein Matrixelement (45) trägt, **dadurch gekennzeichnet, daß** der das Substrat (20) tragende flache Tisch (19) längs der Achse (x) beweglich ist und am unteren Teil mit einem flachen Tisch (12) starr verbunden ist, der längs der Achse (y) beweglich ist, daß wenigstens die Betätigungen des flachen Tisches (19) längs der Achse (x) und die des flachen Tisches längs der Achse (y) und der Lochstanzantrieb (22) längs der Achse (z) mittels Linearmotoren (13a, 13b, 13c, 13d) erhalten werden, die mit ihren Achsen parallel zu den jeweiligen Achsen der Positionierung (x, y, z) angeordnet sind, daß wenigstens die flachen Tische (12, 19) auf einem relativen pneumostatischen Trag- und Führungssystem (41, 42, 43; 141, 142, 143) beweglich sind, daß der Lochstanzantrieb (22) mit einem pneumostatischen Trag- und Führungssystem (28, 30) verbunden ist, und daß das Lochstanzgerüst mit einem Drehantrieb (47) bezüglich einer Achse θ zum korrekten Positionieren bezüglich des Substrats (20) verbunden ist.

2. Lochstanzmaschine nach Anspruch 1, bei der der Drehantrieb (47) ein Linearmotor ist.

3. Lochstanzmaschine nach Anspruch 1 oder 2, bei der der Drehantrieb (47) des Lochstanzgerüsts (21) durch Videokameras (46) überwacht wird, um die richtige polare Position des Substrats (20) zu überprüfen.

4. Lochstanzmaschine nach einem der vorstehenden Ansprüche, bei der die Linearmotoren (13a, 13b, 13c) zum Positionieren der flachen Tische (12, 19) bezüglich der Achsen x-y Linearmotoren mit Mehrfach-Hochleistungs-Schwingspulen sind und mehrere Magnete (16, 16a) aufweisen, die auf einem relativ beweglichen Träger (17, 17a) befestigt sind und zu Stromleitelementen (15, 15a) gewandt sind, wobei die Stromleitelemente (15, 15a) auf einen relativen Kern (14, 14a) gewickelt sind und unabhängig und autonom entsprechend der relativen Lage bezüglich der Magnete (16, 16a) gespeist werden.

5. Lochstanzmaschine nach einem der vorstehenden Ansprüche, wobei der Linearmotor (13d) zum Antreiben des Lochstanzantriebs (22) bezüglich der Achse (z) ein Linearmotor mit einer Schwingspule begrenzter Beweglichkeit ist und stationäre Magnet-Auflageplatten (24) aufweist, die peripher mit einem die Spule (26) tragenden, beweglichen Kern (27) zusammenwirken.

6. Lochstanzmaschine nach Anspruch 5, bei der der Weg (d) des Linearmotors (13d) gleich der Differenz zwischen der vertikalen Größe der Spule (26) und der vertikalen Größe des Magnets (25) ist, die ihnen zugewandt sind.

7. Lochstanzmaschine nach einem der vorstehenden Ansprüche, bei der wenigstens einer der Linearmotoren (13a, 13b, 13c, 13d) End-Halbpole aufweist.

8. Lochstanzmaschine nach einem der vorstehenden Ansprüche, bei der der Lochstanzantrieb (22) am unteren Teil eine Lochstanz-Auflageplatte (33) aufweist, die wenigstens zwei Locher (48) trägt, die gleichzeitig auf das Substrat (20) einwirken.

9. Lochstanzmaschine nach einem der Ansprüche 1 bis 7, bei der die Lochstanz-Auflageplatte (33) mehrere Locher (48) trägt, die je mit einem relativen Antrieb verbunden sind, der unabhängig und autonom angetrieben wird.

10. Lochstanzmaschine nach einem vorstehenden Ansprüche, bei der eine oder mehrere Lochanordnungen (39) einer Förderlinie (35) zugeordnet sind.

11. Lochstanzmaschine nach einem der vorstehenden Ansprüche, mit rotierenden Handhabungseinrichtungen (37) zur Übertragung der Substrate (20) von der Förderlinie (35) zu dem flachen Tisch (19).

12. Lochstanzmaschine nach einem der vorstehenden Ansprüche, die am hinteren Teil einen Bedienungsbereich (49) zum Wechseln der Formen aufweist.

## Revendications

1. Machine de poinçonnage utilisée dans la préparation de substrats (20) pour les microcircuits électriques, tels que par exemple, les feuilles de bande vierge, la machine comprenant une table support mobile selon les deux axes (x, y) dans un plan horizontal en liaison avec un bâti de poinçonnage (21), le bâti de poinçonnage (21) supportant un actionneur de poinçonnage mobile selon l'axe vertical (z) et ayant en partie basse une empreinte (44) et une matrice (45), la machine étant **caractérisée en ce que** la table plate (19), laquelle supporte le substrat (20), est mobile le long de l'axe (x) et est associée d'une manière rigide en partie basse avec la table plate (12) mobile selon l'axe (y), **en ce que** les mouvements de la table plate (19) le long de l'axe (x), et ceux de la table plate (12) le long de l'axe (y) et l'actionneur de poinçonnage (22) le long de l'axe (z) sont obtenus au moyen de moteurs linéaires (13a, 13b, 13c, 13d) disposés de sorte que leur axe soit parallèle aux axes respectifs de positionnement (x, y, z), **en ce que** au moins les tables plates (12, 19) se déplacent sur un support pneumostatique associé et un système de guidage (41, 42, 43 ; 141, 142, 143), **en ce que** l'actionneur de poinçonnage (22) est associé à un support pneumostatique et un système de guidage (28, 30) et **en ce que** ledit bâti de poinçonnage (21) est associé à un actionneur rotatif (47) selon un axe σ pour le positionnement correct par rapport au substrat (20).

2. Machine de poinçonnage selon la revendication 1, dans laquelle l'actionneur de rotation (47) est un moteur linéaire.

3. Machine de poinçonnage selon les revendications 1 ou 2, dans laquelle l'actionneur de rotation (47) du bâti de poinçonnage (21) est piloté par des caméras vidéo (46) pour vérifier la position polaire correcte du substrat (20).

4. Machine de poinçonnage selon l'une des revendications précédentes, dans laquelle les moteurs linéaires (13a, 13b, 13c) de positionnement des tables plates (12, 19) par rapport aux axes x-y sont des moteurs linéaires du type à bobine mobile multiple à déplacement élevé et incluent une pluralité d'aimants (16, 16a) fixés à un support mobile associé (17, 17a) et en face des éléments conducteurs de courant (15, 15a), ces éléments conducteurs de courant (15, 15a) étant bobinés sur un noyau associé (14, 14a) et étant alimentés indépendamment et de façon autonome selon la position relative en regard des aimants (16, 16a).

5. Machine de poinçonnage selon l'une des revendications précédentes, dans laquelle le moteur linéaire (13d) d'entraînement de l'actionneur de poinçonnage (22) selon l'axe (z) est un moteur linéaire du type à bobine mobile multiple à déplacement faible, et comprend des plaques support d'aimant fixes (24) disposées pour coopérer en périphérie avec un noyau mobile (27) supportant l'enroulement (26).

6. Machine de poinçonnage selon la revendication 5, dans laquelle la course (d) du moteur linéaire (13d) est égale à la différence entre la dimension verticale de l'enroulement (26) et la dimension verticale des aimants (25) qui leur font face.

7. Machine de poinçonnage selon l'une des revendications précédentes, dans laquelle au moins un des moteurs linéaires (13a, 13b, 13c, 13d) est du type à demi pôles d'extrémité.

8. Machine de poinçonnage selon l'une des revendications précédentes, dans laquelle l'actionneur de poinçonnage (22) a en partie basse une plaque support de poinçons (33) soutenant au moins une paire de poinçons (48) pour agir simultanément sur le substrat (20).

9. Machine de poinçonnage selon l'une des revendications 1 à 7 inclus, dans laquelle la plaque support de poinçons (33) soutient une pluralité de poinçons (48), chacun d'entre eux est associé à un actionneur propre qui est piloté indépendamment et de façon autonome.

10. Machine de poinçonnage selon l'une des revendications précédentes, qui a une ou plusieurs structures de poinçonnage (39) associée à une ligne d'alimentation (35).

11. Machine de poinçonnage selon l'une des revendications précédentes, qui a des dispositifs de préhension rotatifs (37) pour transférer les substrats (20) à partir de la ligne d'alimentation (35) sur la table plate (19).

12. Machine de poinçonnage selon l'une des revendications précédentes, qui a en partie arrière une aire de maintenance (49) destinée à changer les empreintes.
